Europäisches Patentamt

European Patent Office

Office européen des brevets

(19)

(11) Publication number: **0 151 898**

**A2**

(12)

# EUROPEAN PATENT APPLICATION

(21) Application number: **84630219.8**

(22) Date of filing: **28.12.84**

(51) Int. Cl.⁴: **G 11 C 11/24**

(30) Priority: **05.01.84 US 568554**

(43) Date of publication of application:
**21.08.85 Bulletin 85/34**

(84) Designated Contracting States:
**DE FR GB NL**

(71) Applicant: **MOSTEK CORPORATION**
**1215 West Crosby Road**
**Carrollton, TX 75006(US)**

(72) Inventor: **Taylor, Ronald Thomas**
**4289 Pleasant Run**
**149 Irving Texas 75217(US)**

(74) Representative: **Waxweiler, Jean et al,**
**OFFICE DENNEMEYER S.à.r.l. 21-25 Allée Scheffer**
**P.O.Box 41**
**L-2010 Luxembourg(LU)**

(54) Method and appartus for equilibrating a memory cell.

(57) An equilibration circuit for dynamic RAMs connects the true and complement bit lines to the cell plate and to a reference voltage.

FIG. 3

EP 0 151 898 A2

Croydon Printing Company Ltd.

0151898

Method and Apparatus
for Equilibrating a Memory Cell

Technical Field

The field of the invention is that of integrated circuit dynamic random access memories (DRAMs). In particular, the field is that of equilibrating bit lines within the memory cell array.

Background Art

In dynamic RAMs, the standard method of reading out the stored data is to use a sense amplifier which has as inputs a pair of bit lines, (referred to in the field as the true and complement bit lines) which are forced to have an equal voltage (equilibrated) in the period just before the sensing operation is done.

A standard architecture in the field is the Vcc/2 architecture, in which the complementary pair of bit lines are forced to a voltage which is half the supply voltage. A logical one which is stored as the full supply voltage raises the voltage on the bit line when it is read-out and a logical zero will lower the voltage on the bit line. The sense amplifier responds to this voltage shift to produce an output that represents the data in the cell. In this case, the capacitor within the memory cell has the full supply voltage stored on it, thus producing a strain on the dielectric within the capacitor. In order to have a desired level of reliability, the dielectric between the top plate of the capacitor and the cell plate must be made thicker and therefore the area of the capacitor must be increased. Since the capacitor area is greater, the area of the memory cell will also be greater.

Disclosure of Invention

The invention relates to a dynamic RAM having true and complement bit lines and an equilibration circuit that connects the cell plate to both the bit lines at a common voltage reference.

A feature of the invention is that the electric field during the equilibration step is reduced by a factor of two.

Brief Description of Drawings

Figure 1 illustrates a prior art circuit.

Figure 2 illustrates another prior art circuit.

Figure 3 illustrates an embodiment of the invention.

Best Mode of Carrying Out the Invention

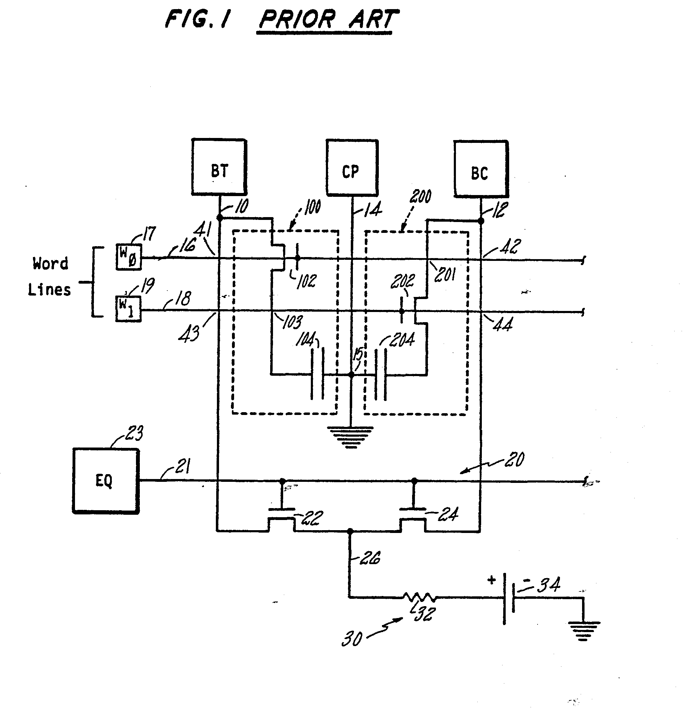

Figure 1 illustrates a prior art circuit including a small portion of a memory array containing memory cells 100 and 200 connected to bit lines 10 and 12 and word lines 16 and 18, respectively. Cells 100 and 200 share a common cell plate line, 14, and cell plate node, 15, which, in this case, is connected to ground. An equilibration circuit 20 consists of a pair of connecting transistors 22 and 24 controlled by equilibration line 21 which in turn is controlled by equilibration circuit 23. Equilibration circuit 23 applies voltage to line 21 at the proper time to force bit lines 10 and 12 equal to the voltage on node 26.

That voltage, in turn, is set by reference supply 30 which consists of reference voltage circuit 34 which supplies a voltage that is nominally half the supply voltage and series resistor 32 which represents the impedance of circuit 34. In operation, line 21 goes high, at the equilibration time, turning on transistors 22 and 24 and providing a low impedance path connecting node 26 to bit lines 10 and 12.

The circuit shown is only a small portion of the memory array, of course, and many other cells will be added to the extension of bit lines 10 and 12 and to the extension of word lines 16 and 18.

In order to have the high degree of circuit reliability that is standard in current integrated circuit practice, care must be taken to reduce the strain imposed on dielectrics by the electrical fields that are formed between the various circuit elements. The circuit of Figure 1 has two capacitors, 104 and 204, that store the data and a number of parasitic capacitors described below.

When a logical one is stored in the circuit of Figure 1, the capacitor within the memory cell will have the full supply voltage stored across it. If the cell plate node were to be maintained at Vcc, then there would be no strain on a capacitor that was storing a logical one but there would be the same strain on a capacitor storing a logical zero since node 15 would be at Vcc and the other side of the capacitor would be at ground. Numerals 41, 42, 43 and 44 indicate points where bit lines cross word lines. Parasitic capacitors will be formed at these points and will be subject to a strain that depends on the voltage impressed across the two elements of the capacitors. During the equilibration step, word lines 16 and 18 will be held at zero volts by circuits 17 and 19, which schematically represent the overhead circuitry which controls the word lines. Bit lines 10 and 12 will be equilibrated at Vcc/2, so that is the maximum impressed voltage on these capacitors.

There are also parasitic capacitors within the memory cell, at point 103 where word line 18 crosses the connection between transistor 102 and capacitor 104 and at point 201 where word line 16 crosses the connection between transistor 202 and bit line 12. The capacitor at point 201 will only have Vcc/2 impressed on it during equilibration, but the capacitor at point 103 will have the full Vcc impressed on it.

Referring now to Figure 2, there is shown another prior art circuit which differs in the equilibration circuit and in the connection of the cell plate. Elements of the circuit that are at the same in Figure 2 as in Figure 1 have been given the same numeral. In this case, cell plate node 15 is connected directly to voltage circuit 30 to maintain the cell plate at a DC voltage of Vcc/2. Equilibration circuit 30 has been divided into two portions. Transistors 22' and 24' are now connected between Vcc and the corresponding bit lines 10 and 12. Circuit 23' bootstraps line 21 above Vcc to turn on transistors 22' and 24'. In the equilibration step of this circuit, the bit lines 10 and 12 will be forced equal to the full supply voltage Vcc. The strain on parasitic capacitors 41, 42, 43 and 44 and the capacitor at point 201 will be that of the full supply voltage. The capacitor at point 103 will be unchanged. The strain on capacitor 104 or 204 in the memory cell, however, will now be less, since the voltage across one of these capacitors will be Vcc/2, whether the cell is storing a logical one or a logical zero. This is an advantage, since the dielectric of capacitors 104 and 204 is the most sensitive.

There is a drawback with the circuit of Figure 2, in that the voltage coming from the circuit of 23' must rise above the supply voltage in order to turn on transistors 22' and 24'. This modification of circuit 23 imposes a significant reliability problem since the circuits required to bootstrap a voltage above the supply voltage are sensitive to small leakage currents.

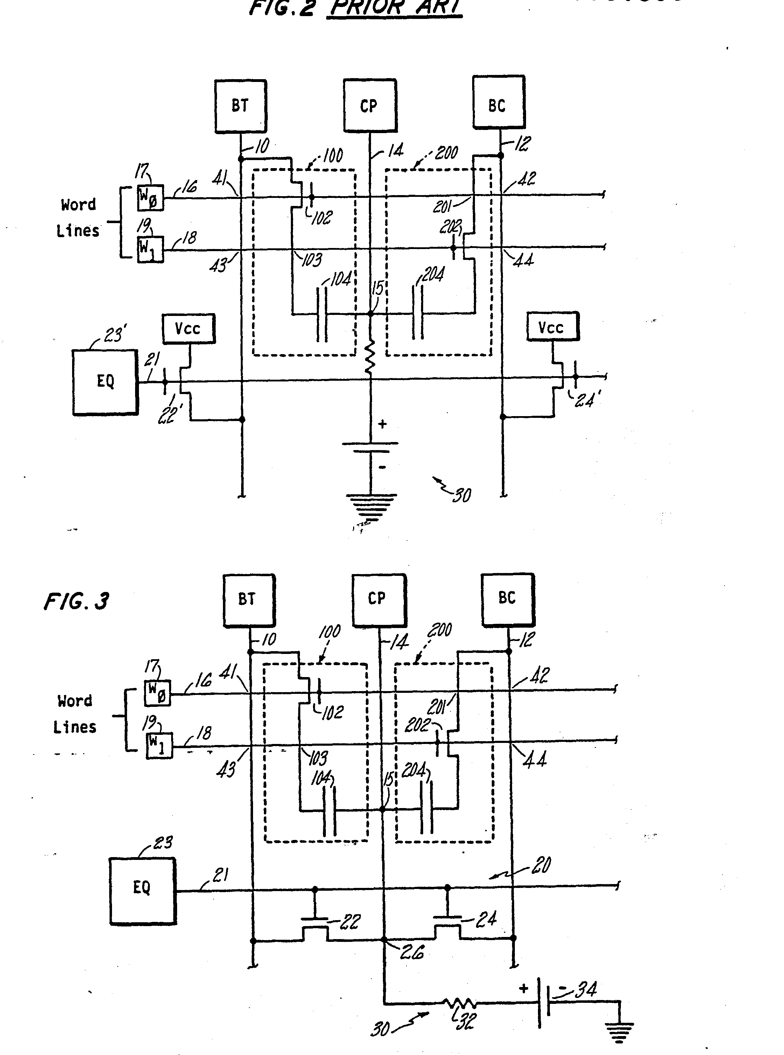

Figure 3 illustrates an embodiment of the invention in which equilibration circuit 20 is now connected to cell plate node 15, so that equilibration node 26 and cell plate node 15 are maintained at the voltage Vcc/2 by voltage circuit 30. With this configuration, the voltage across capacitors 104 and 204 will be Vcc/2, regardless of whether the capacitor is storing a logical one or a logical zero. Also, the parasitic capacitors 41, 42, 43 and 44, as well as the capacitor at point 201 will also have an impressed voltage of Vcc/2. Only the parasitic capacitor at point 103 will have the full supply voltage across it when cell 100 is storing a logical one. This circuit preserves the benefit of the circuit in Figure 2 - that of impressing only half the supply voltage across the most critical dielectric in capacitors 104 and 204. It further retains the advantages of the circuit of Figure 1 with regard to the parasitic capacitors 41-44. The drawback of having the full supply voltage impressed across the parasitic capacitor at point 103 is the same in the present invention as it is in the prior art of Figure 1 or Figure 2. It is considerably easier to provide adequate insulation at point 103, since the standard processing techniques use a thick layer of silicon oxide or other dielectric in order to suppress transient coupling between the word line and the cell.

## Claims

1.    A semiconductor memory circuit having an array of
memory cells, each cell having a cell plate with one
terminal of a capacitor connected to it and a set of
true and complement bit lines connected to selected
ones of said cells; and

an equilibration circuit for connecting, in pairs,
selected true and complement bit lines to an equilibration voltage means; characterized in that:

said equilibration circuit comprises first and
second transistors, controlled by said equilibration
voltage means, each having a first terminal connected
to an equilibration node and a second terminal connected
to one of said true and complement bit lines; and

said equilibration node is connected directly to a
cell plate node common to a cell plate of at least two
of said array of cells and said equilibration node is
connected to voltage means for maintaining said equilibration node at a predetermined voltage substantially half
way between a circuit supply voltage and ground.

*FIG./* *PRIOR ART*

# FIG.2 *PRIOR ART*

0151898

# FIG.3